**Europäisches Patentamt**

**European Patent Office**

**Office européen des brevets**

(19)

(11) Veröffentlichungsnummer: **0 042 576**
**B1**

(12) **EUROPÄISCHE PATENTSCHRIFT**

(51) Int. Cl.³: **H 03 K 5/01**, G 05 F 1/46

(45) Veröffentlichungstag der Patentschrift:
05.12.84

(21) Anmeldenummer: **81104632.5**

(22) Anmeldetag: **16.06.81**

(54) **Störspannungen unterdrückende Schaltungsanordnung aus mehreren gemeinsam gespeisten Treiberschaltungen.**

(30) Priorität: **23.06.80 US 162344**

(43) Veröffentlichungstag der Anmeldung:
**30.12.81 Patentblatt 81/52**

(45) Bekanntmachung des Hinweises auf die Patenterteilung:
**05.12.84 Patentblatt 84/49**

(84) Benannte Vertragsstaaten:
**DE FR GB IT**

(56) Entgegenhaltungen:
**US - A - 3 010 027**
**US - A - 3 213 433**
**US - A - 3 243 787**
**US - A - 4 045 684**

**IBM TECHNICAL DISCLOSURE BULLETIN, Band 17, no. 5, Oktober 1974 NEW YORK (US) SONODA: "Active decoupling circuit", Seite 1369**
**IBM TECHNICAL DISCLOSURE BULLETIN, Band 19, no. 2, Juli 1976 NEW YORK (US) CHU: "On-Chip Constant-Current Compensator" Seiten 500-501**

(73) Patentinhaber: **International Business Machines Corporation, Old Orchard Road, Armonk, N.Y. 10504 (US)**

(72) Erfinder: **Maley, Gerald Adrian, Lookout Road, Fishkill New York 12524 (US)**

(74) Vertreter: **Neuland, Johannes, Dipl.-Ing., Schönaicher Strasse 220, D-7030 Böblingen (DE)**

ACTORUM AG

## Beschreibung

Die Erfindung bezieht sich auf eine Störspannungen unterdrückende Schaltungsanordnung aus mehreren gemeinsam gespeisten Treiberschaltungen für zweipegelige Datensignale, bei der jede Treiberschaltung mit je einer von mehreren Eingangssignalleitungen verbunden ist.

Das Erzeugen von internen Störspannungen durch schaltende Informationsverarbeitungsschaltungen ist seit langem als ein grosses Problem erkannt worden. Es gibt in Informationssignale verarbeitenden Schaltungen viele Quellen für intern erzeugte Störspannungen. Die meisten Fachleute lassen als Hauptgrund die unzureichende Entkopplung von der Stromversorgung in irgendeiner Stufe der Gesamtschaltung gelten. Sei dem, wie ihm wolle, das Problem existiert noch in vielen Aspekten, von denen die verteilte Wirkung von Schaltvorgängen, die in irgendeiner Stufe der Gesamtschaltung erzeugt werden, nicht der geringste ist. Viele Lösungen sind angeboten worden und viele von ihnen sind vielversprechend. Aber es ist noch Raum für Verbesserungen vorhanden.

In dem U.S. Patent 3 010 027 ist eine Schaltung zum Konstanthalten des Stromes beschrieben, der einer variierenden Anzahl von Stromverbrauchern zugeführt wird, wenn die Verbraucher in den Stromkreis mit der Stromquelle ein- oder aus ihm ausgeschaltet werden durch Verwenden eines steuerbaren, kompensierenden Serien-Impedanzelementes und eines Transformators, die so angeordnet sind, dass sie die kompensierende Impedanz im Gegensatz zur Lastimpedanz darstellen.

Aus dem U.S. Patent 3 213 433 ist eine Schaltung bekannt, bei der der Strom für eine sich ändernde Anzahl von Stromverbrauchern dadurch konstant gehalten wird, dass der Gesamtstrom entweder die Verbraucher durchfliesst oder eine in dem Schaltkreis vorhandene Stromsenke, die den gleichen Strom der Stromquelle entnimmt.

In dem U.S. Patent 3 243 787 ist eine Schaltungsanordnung beschrieben, bei der jedes einer Reihe von elektrischen Bauelementen mit einem anderen, im wesentlichen gleichen, aber eine Ersatzlast darstellenden Bauelement zusammengehört, wodurch der Speisestrom im wesentlichen konstant ist.

In dem U.S. Patent 3 467 953 ist ein System offenbart, bei dem das Entstehen der Störspannung nicht verhindert wird, aber diese festgestellt und neutralisiert wird durch eine Schaltung, die die Störspannung invertiert und danach an einem Punkt in dem System aufhebt. Der Strom einer Stromquelle wird durch eine Schaltung entsprechend der Störspannung in dieser Schaltung eingestellt.

Aus dem U.S. Patent 3 643 239 ist das Konzept bekannt, die Schaltungskomponenten in vorbestimmte Gruppen zu unterteilen, wobei diese Komponenten gruppenweise zusammenarbeiten, um die Störspannung mittels der Übertragungsleitungen zu verringern und dadurch die Störspannungskomponente des Signals zu neutralisieren.

Während die in den genannten Patenten beschriebenen Schaltungen ein oder zwei Merkmale mit der vorliegenden Erfindung gemeinsam haben, zeigt eine Prüfung, dass jede der Konzepte und der Mittel zu ihrer Realisierung ermangelt, um eine Schaltungsanordnung zu schaffen, bei der das Entstehen von Störspannungen weitgehend unterdrückt ist.

Hier will die Erfindung Abhilfe schaffen. Die Erfindung, wie sie in den Ansprüchen gekennzeichnet ist, löst die Aufgabe, eine Schaltungsanordnung aus mehreren gemeinsam gespeisten Treiberschaltungen für zweipegelige Datensignale anzugeben, bei der das Entstehen von Störspannungen von vornherein weitgehend dadurch unterdrückt ist, dass der die durch die Stromversorgungsleitungen gebildete Induktivität durchfliessende Strom stets konstant gehalten wird. Dies wird dadurch erreicht, dass eine Reihe von Hilfs-Treiberschaltungen vorgesehen sind, von denen jeweils so viele eingeschaltet werden, dass der sie und die Treiberschaltungen durchfliessende Gesamtstrom gleich bleibt.

Im folgenden wird die Erfindung in Verbindung mit den Zeichnungen näher erläutert.

Es zeigt:

Fig. 1 ein Schaltbild eines Ausführungsbeispieles der Treiberschaltung gemäss der Erfindung;

Fig. 2 ein Schaltbild einer als Beispiel dienenden Treiberschaltung, die in der Schaltungsanordnung gemäss der Erfindung Verwendung finden kann;

Fig. 3 ein Schaltbild eines Volladdierwerkes, das für die Anwendung der Erfindung nützlich ist und

Fig. 4 eine graphische Darstellung von Kurvenverläufen, die für das Verständnis der Erfindung nützlich sind.

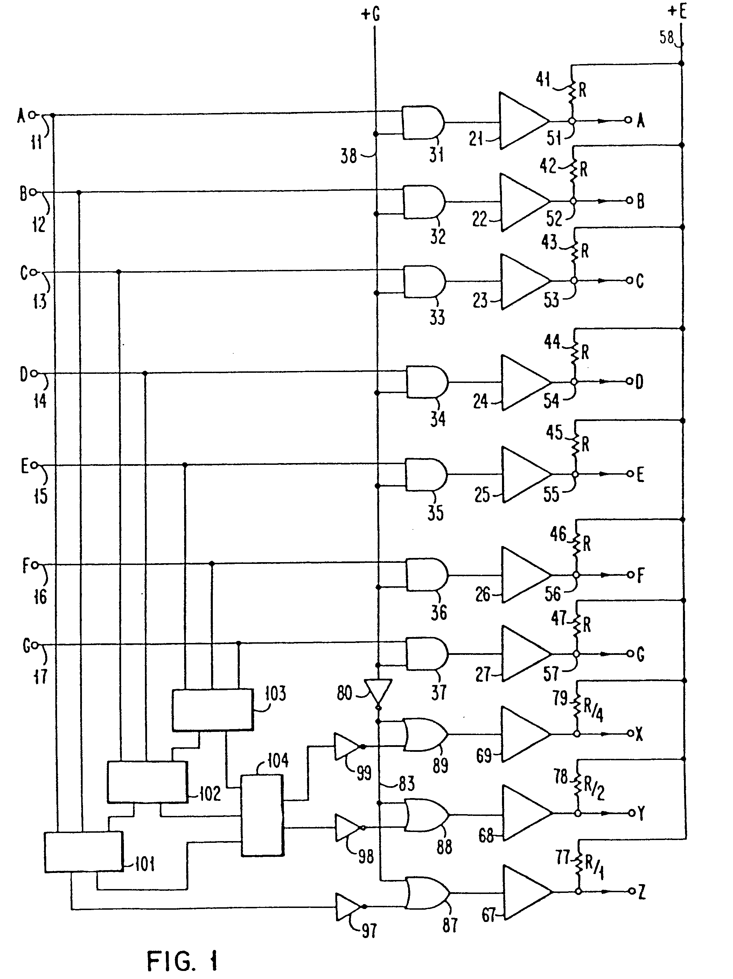

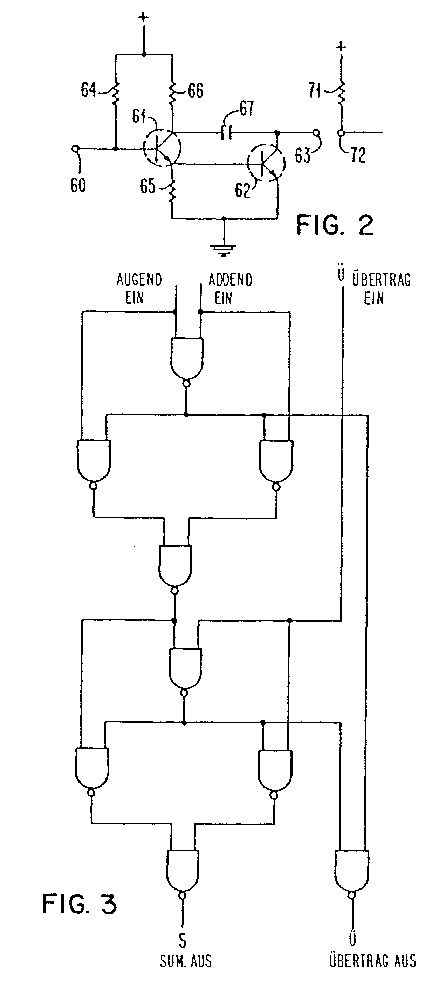

Das Schaltbild eines Ausführungsbeispieles einer erfindungsgemässen Treiberschaltungsanordnung für zweipegelige Signaldaten ist in Fig. 1 dargestellt. Ein zweipegeliges, geschaltetes Signal ist auf jeder aus einer Reihe von Signaleingangsleitungen 11, 12 ... 17 vorhanden zur Zuführung zu den Treiberschaltungen 21, 22 ... 27, vorzugsweise mittels einzelner UND-Glieder 31, 32 ... 37, die alle mit einer gemeinsamen Signal-Durchschaltleitung 38 verbunden sind. Die Treiberschaltungen 21–27 sind als Schaltugnen mit «offenem Kollektor» dargestellt. Ein Beispiel für eine Schaltung mit «offenem Kollektor», die unter vielen anderen für die Ausübung der Erfindung geeignet ist, ist in Fig. 2 dargestellt.

Ein Eingangsanschluss 60 ist mit der Basiselektrode eines Eingangstransistors 61 verbunden, dessen Emitterelektrode an die Basiselektrode eines Ausgangstransistors 62 angeschlossen ist, der wiederum mit einem Ausgangsanschluss 63 verbunden ist. Ein Vorspannungswiderstand 64 ist vorgesehen, um den Eingangstransistor 62 vorzuspannen. Ein Emitterwiderstand 65 entwickelt ein Potential zwischen dem Emitter des Eingangstransistors 61 und Massepotential, an das die Emitterelektrode des Ausgangstransistors 62 angeschlossen ist. Ein Lastwiderstand 66 vervollständigt die Schaltung des Eingangstransistors 61 und ein Beschleunigungskondensator 67 ist zwischen den Kollektorelektroden des Eingangs- und des Ausgangstransistors angeschlossen. Die Kollektorelektrode des Ausgangstransistors 62 ist, wie dargestellt, «offen» gelassen. Das heisst, die Kollektorelektrode ist direkt an den Ausgangsanschluss 63 herausgeführt und kein Lastwiderstand ist intern in der Treiberschaltung vorgesehen. Dies wurde so gemacht, damit der Entwerfer der Schaltung den Wert des Lastwiderstandes oder sogar die Art der Belastung, beispielsweise ein Solenoid zur Erregung eines Relais, wählen kann. Im dargestellten Fall ist die Belastung ein Widerstand 71, der mit dem Eingangsanschluss 72 der nachfolgenden Schaltung und mit dem Ausgangsanschluss 63 der Treiberschaltung verbunden ist. In dieser Weise wird der Transistor 62 gespeist und das Ausgangssignal bildet sich mittels des Lastwiderstandes 71 aus.

In Fig. 1 sind die Lastwiderstände 41, 42 ... 47 einzeln an die Ausgangsanschlüsse 51, 52 ... 57 der Treiberschaltungen 21–27 angeschlossen, um die Schaltung im wesentlichen zu vervollständigen, wie das in Fig. 2 gezeigt ist. Alle Lastwiderstände haben im wesentlichen den gleichen Wert und sind an eine gemeinsame Leitung 58 für das Zuführen des Speisepotentials angeschlossen.

Wenn das zweipegelige Signal zu irgendeinem Zeitpunkt auf den Signaleingangsleitungen 11–17 erscheint, können sieben, sechs ... eine oder keine Einheit des Stromes von der Speisespannungsquelle über die Leitung 58 fliessen. Diese weite Variation in dem fliessenden Strom hat die Tendenz, interne Störspannungen in der Schaltung zu erzeugen, worin sich eine unzureichende Entkopplung der Stromversorgung als ein Beispiel für die Ursache dieses unerwünschten Effektes widerspiegelt.

Gemäss der Erfindung wird die aus dieser Quelle stammende interne Störspannung der Schaltung unterdrückt durch das Hinzufügen der redundanten Treiberschaltungen 67, 68 und 69, die vorzugsweise identisch mit den Datentreiberschaltungen sind. Die Anzahl dieser redundanten Treiberschaltungen, die für eine bestimmte Anwendung benötigt werden, ist geringer als die Anzahl der Datentreiberschaltungen durch Festsetzen der Werte für die Lastwiderstände gemäss der Erfindung. Der Lastwiderstand 77 besitzt einen Wert, der gleich ist den Werten der Lastwiderstände 41, 42 ... 47 der Datentreiberschaltungen, wodurch beim Einschalten der redundanten Treiberschaltung 67 eine Stromeinheit diese Last durchfliesst. Der Lastwiderstand 78 erhält einen Wert, der die Hälfte desjenigen der Lastwiderstände der Datentreiberschaltungen beträgt, wodurch ihn zwei Einheiten des Stromes durchfliessen. Der folgende Lastwiderstand 79 hält einen Wert, der ein Viertel desjenigen der Lastwiderstände der Datentreiberschaltungen beträgt, wodurch ihn vier Einheiten des Stromes durchfliessen. Für mehr als sieben Datentreiberschaltungen wird der Wert des nachfolgenden Lastwiderstandes der redundanten Schaltung entsprechend der nächsten Binärstelle, nämlich acht, auf R/8 verringert usw. Die Tabelle I gibt die Anzahl der N der redundanten Treiberschaltungen für die Anzahl M von Datentreiberschaltungen an.

Tabelle I

| L | M Leitungen | N Treiberschaltungen |
|---|---|---|
| 1 | 2– 3 | 2 |
| 2 | 4– 7 | 3 |
| 3 | 8–15 | 4 |
| 4 | 16–31 | 5 |

Für eine Schaltungsanordnung mit sieben Treiberschaltungen für Eingangdaten und drei redundanten Trieberschaltungen, wie sie in Fig. 1 gezeigt ist, zur Darstellung von 128 verschiedenen Zeichen aus jeweils sieben Signalelementen ziehen die ausgewählten Treiberschaltungen jeweils sieben Einheiten des Stromes, wie das aus der Tabelle II, die für ein Alphabet mit Zeichen aus sieben Elementen gilt, ersichtlich ist.

Tabelle II

| L | M | | | | | | | N | | |
|---|---|---|---|---|---|---|---|---|---|---|
| | A | B | C | D | E | F | G | 1 | 2 | 4 |
| 0 | 0 | 0 | 0 | 0 | 0 | 0 | 0 | 1 | 1 | 1 |
| 1 | 0 | 0 | 0 | 0 | 0 | 0 | 1 | 0̄ | 1̄ | 1̄ |
| 2 | 0 | 0 | 0 | 0 | 0 | 1 | 0̄ | 0̄ | 1̄ | 1̄ |
| 3 | 0 | 0 | 0 | 0 | 0 | 1̄ | 1 | 1 | 0̄ | 1̄ |
| 4 | 0 | 0 | 0 | 0 | 1 | 0̄ | 0̄ | 0̄ | 1 | 1̄ |
| 7 | 0 | 0 | 0 | 0 | 1̄ | 1 | 1 | 0 | 0̄ | 1̄ |
| 8 | 0 | 0 | 0 | 1 | 0̄ | 0̄ | 0̄ | 0 | 1 | 1̄ |
| 31 | 0 | 0 | 1 | 1̄ | 1 | 1 | 1 | 0 | 1̄ | 0̄ |
| 63 | 0 | 1 | 1̄ | 1̄ | 1̄ | 1̄ | 1̄ | 1 | 0̄ | 0 |
| 127 | 1̄ | 1̄ | 1̄ | 1̄ | 1̄ | 1̄ | 1̄ | 0̄ | 0 | 0 |

Die redundanten Treiberschaltungen 67, 68 und 69 werden mittels einer Steuerschaltung 80 ausgewählt. Die Durchschalteitung 38 ist an eine Inverterschaltung 80 angeschlossen, deren Ausgangsleitung 83 mit dem invertierten Durchschaltsignal an die ODER-Glieder 87, 88 89 angeschlossen ist, die einzelnen mit den redundanten Treiberschaltungen verbunden sind. Eine andere Eingangsleitung jedes der ODER-Glieder 87–89 ist einzeln an weitere Inverterschaltungen 97, 98 und 99 angeschlossen. Vier Volladdierschaltungen 101, 102, 103 und 104 vervollständigen die Steuerschaltung.

Die Addierschaltungen sind übliche binäre Addierschaltungen und vorzugsweise von der in Fig. 3 gezeigten Art. In dieser Figur stellen die Schaltungssymbole bekannte NAND-Glieder dar. Die aufeinanderfolgenden Addierer 103, 102 und 101 sind wie dargestellt miteinander verbunden, wobei die Eingangsleitungen für den Augenden und den Addenden einzeln mit den Dateneingangsleitungen verbunden sind. Wenn eine ungerade Anzahl von Datenleitungen vorliegt, wird die letzte Leitung mit dem Eingangsanschluss für den Übertrag des Addierers 103 der Addierer verbunden, andernfalls wird dieser Eingangsanschluss für den Übertrag so angeschlossen, dass ihm ein Eingangswert «kein Übertrag» ständig zugeführt wird. Die Ausgangsanschlüsse für die Summe der Addierer 103 und 102 sind mit den Übertrags-Eingangsanschlüssen der vorhergehenden Addierer verbunden. Die Übertrags-Ausgangsanschlüsse der drei Addierer 101, 102 und 103 sind mit den drei Eingängen eines weiteren Addierers 104 verbunden. Der Summen-Ausgang des Addierers 101 und der Summen- und Übertrags-Ausgang des weiteren Addierers 104 sind einzeln an die Eingangsanschlüsse der Inverter-Schaltungen 97, 98 und 99 angeschlossen. Die Addierer 103, 102 und 101 bilden die Summe entsprechend den aufsteigenden Binärstellen, wodurch die zugehörige redundante Treiberschaltung von einem Strom durchflossen wird, der erforderlich ist, um die Gesamtlast zu kompensieren.

Die redundanten Treiberschaltungen führen noch eine andere nützliche Funktion gemäss der Erfindung aus. Die Binärzahl der fliessenden Stromeinheiten steht in der Weise in Beziehung zur Anzahl der Datentreiberschaltungen bei einem gegebenen Signalpegel, dass die Anzahl gleich ist der Anzahl von Datentreiberschaltungen, die bei dem zum gegebenen Signalpegel entgegengesetzten Pegel Strom führen, wie das leicht aus der Tabelle II zu ersehen ist. Beispielsweise zeigt die Zeile 3, dass die Dateneingangsleitungen FG den binären 1-Pegel aufweisen und einen Gesamtstrom von zwei Stromeinheiten fliessen lassen und dass die redundanten Treiberschaltungen 1 und 4 Ströme von einer bzw. vier Stromeinheiten fliessen lassen. Daher führen aus der maximalen Gesamtzahl von sieben Stromeinheiten die Datentreiber 2 und die redundanten Treiberschaltungen 5 Stromeinheiten. Nur zwei zusätzliche redundante Treiberschaltungen sind tatsächlich erforderlich, da normalerweise eine Schaltung zur Paritätsprüfung ohnehin erforderlich ist. Die Binärzahl, die auf den redundanten Ausgangsleitungen X, Y und Z verfügbar ist, kann daher für die Fehlerprüfung und ähnliche Zwecke verwendet werden. Beispielsweise kann eine Schaltung ähnlich der Treiberschaltungsanordnung an einem entfernten Endgerät zur Regenerierung der X, Y, Z Werte vorgesehen sein und diese Werte werden in einer einfachen Vergleichsschaltung mit den X, Y und Z Bits, verglichen, die mit den Daten eintreffen. Die Verfahren bezüglich des Hamming-Alphabetes sind anwendbar.

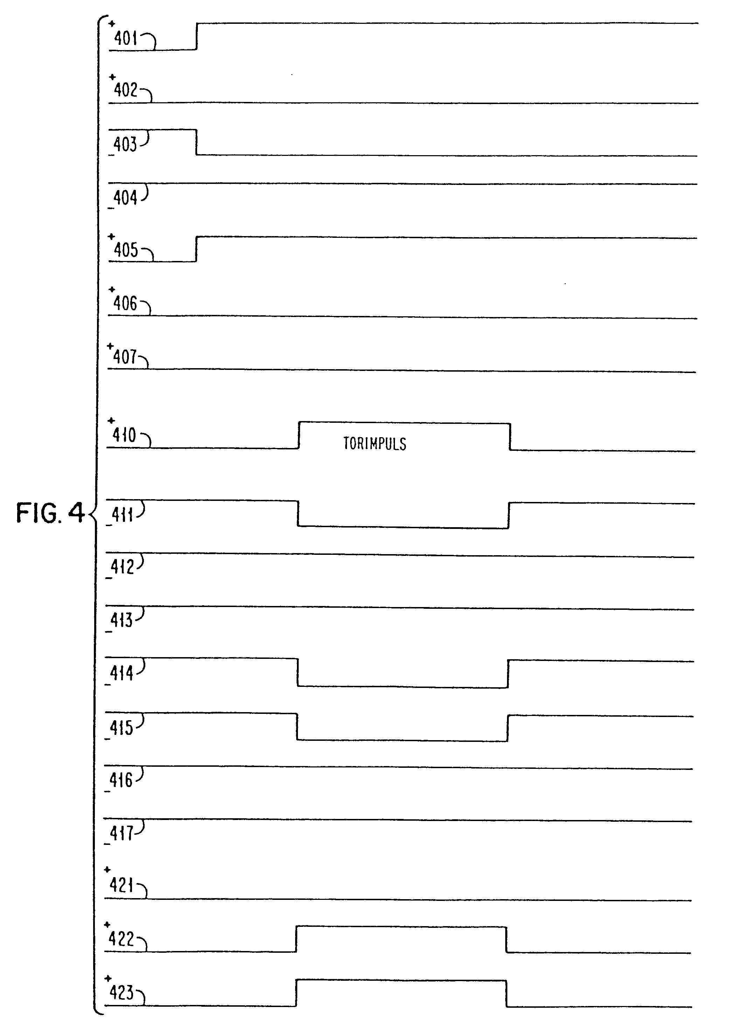

Fig. 4 ist eine graphische Darstellung von Spannungsverläufen an verschiedenen Punkten der Schaltungsanordnung gemäss der Erfindung und dient dem Verständnis der Wirkungsweise.

Die Kurven 401, 402 . . . 407 stellen ein Beispiel der auf den Leitungen 11, 12 . . . 17 (Fig. 1) vorhandenen Daten dar. Die Anfangsdaten zum Zeitpunkt $t_0$ sind, wie dargestellt, 1, Ø, Ø, 1, 1, Ø, Ø. Zum Zeitpunkt $t_1$ ändern sie sich in die durch Kurvenverläufe 411, 412 . . . 417 dargestellten Daten Ø, 1, 1, Ø, Ø, 1, 1, was sich feststellen lässt, wenn der durch die Kurve 410 dargestellte Durchschaltpegel ansteigt. Die Daten X, Y und Z betragen, wie das durch die Kurven 421, 422 und 423 gezeigt wird, nach dem Zeitpunkt $t_2$ und vor dem Zeitpunkt $t_3$, zu dem der Durchschaltpegel abfällt, Ø, 1, 1.

Die stromführenden redundanten Treiberschaltungen sind daher geringer in der Anzahl als die Datentreiberschaltungen, welche sie kompensieren und ihre relative Anzahl ist sogar noch geringer, wenn die Anzahl der Elemente pro Zeichen erhöht wird. die obere Grenze wird festgesetzt durch die Tatsache, dass der Strom, der durch die nächste redundante Treiberschaltung fliesst, für jede zusätzliche redundante Treiberschaltung verdoppelt wird. Die Steuerschaltung vergrössert sich nur arithmetisch und bleibt daher sehr einfach für jede Anzahl von Zeichenelementen.

**Patentansprüche**

1. Störspannungen unterdrückende Schaltungsanordnung aus mehreren gemeinsam gespeisten Treiberschaltungen für zweipegelige Datensignale, bei der jede Treiberschaltung mit je einer von mehreren Eingangssignalleitungen (11–17) verbunden ist, dadurch gekennzeichnet, dass zum Unterdrücken von Störspannungen, die beim Schalten der Treiberstufen aufgrund der Induktivität der Stromversorgungsleitungen entstehen, eine Reihe von Hilfs-Treiberschaltungen (67–69), die an die gleiche Speisespannungsquelle (+E) wie die übrigen Treiberschaltungen (21–27) angeschlossen sind, und eine Steuerschaltung (80–104) für die Hilfs-Treiberschaltungen vorgesehen sind, dass die Eingänge der Steuerschaltung an die Eingangssignalleitungen (11–17) und ihre Ausgänge an die Hilfs-Treiberschaltungen angeschlossen sind und die Steuerschaltung die Anzahl derjenigen an die Eingangssignalleitungen angeschlossenen Treiberschaltungen feststellt, denen der eine Pegel des Datensignals zugeführt wird und eine entsprechende Anzahl der Hilfs-Treiberschaltungen einschaltet, um den der Speisespannungsquelle entnommenen Strom konstant zu halten.

2. Schaltungsanordnung nach Anspruch 1, dadurch gekennzeichnet, dass die Ausgänge (X, Y, Z) der Hilfs-Treiberschaltungen mit Schaltungen zur Fehlerprüfung verbunden sind.

3. Schaltungsanordnung nach den Ansprüchen 1 und 2, dadurch gekennzeichnet, dass jede der Treiberschaltungen und eine der Hilfs-Treiberschaltungen im leitenden Zustand den gleichen Strom führt, der als Bezugseinheit dient, während die restlichen Hilfs-Treiberschaltungen unterschiedliche Ströme führen, die aufeinanderfolgenden Zweierpotenzen der Bezugseinheit entsprechen.

4. Schaltungsanordnung nach den Ansprüchen 1 bis 3, dadurch gekennzeichnet, dass die Treiberschaltungen und eine der Hilfs-Treiberschaltungen gleiche Lastwiderstände aufweisen, während die Lastwiderstände der restlichen Hilfs-Treiberschaltungen kleinere Werte besitzen, die bezüglich der Lastwiderstände gleichen Wertes den Kehrwerten aufeinanderfolgender Zweierpotenzen entsprechen.

5. Schaltungsanordnung nach den Ansprüchen 1 bis 4, dadurch gekennzeichnet, dass zwischen den Eingangssignalleitungen und den Treiberschaltungen Torschaltungen (31–37) angeordnet sind, deren Steuereingänge an eine gemeinsame Steuerleitung (38) angeschlossen sind.

6. Schaltungsanordnung nach den Ansprüchen 1 bis 5, dadurch gekennzeichnet, dass die Steuerschaltung für die Hilfs-Treiberschaltungen mehrere Addierer (101–104) enthält.

7. Schaltungsanordnung nach den Ansprüchen 1 bis 6, dadurch gekennzeichnet, dass die Hilfs-Treiberschaltungen über ODER-Glieder (87–89) mit zwei Eingängen angesteuert werden, deren erste Eingänge miteinander verbunden und über einen Inverter (80) an die gemeinsame Steuerleitung für die Torschaltungen der Treiberschaltungen angeschlossen sind, während die zweiten Eingänge der ODER-Glieder über Inverter (97–99) mit Ausgängen der Addierer verbunden sind.

## Claims

1. Noise suppressing circuit arrangement consisting of several jointly fed driver circuits for bilevel data signals, where each driver circuit is connected to one respective of several input signal lines (11–17), characterized in that for suppressing noise which originates from the switching of the driver stages due to the inductivity of the current supply lines a number of auxiliary driver circuits (67–69) connected to the same feeding voltage source (+E) as the other driver circuits (21–27), and a control circuit (80–104) for the auxiliary driver circuits are provided, that the inputs of the control circuit are connected to the input signal lines (11–17), and its outputs to the auxiliary driver circuits, and that the control circuit determines the number of those driver circuits connected to the input signal lines to which the one level of the data signal is applied, and switches on a corresponding number of the auxiliary driver circuits to keep constant the current from the feeding voltage source.

2. Circuit arrangement as claimed in claim 1, characterized in that the outputs (X, Y, Z) of the auxiliary driver circuits are connected to error checking circuits.

3. Circuit arrangement as claimed in any one of claims 1 and 2, characterized in that each of the driver circuits and one of the auxiliary driver circuits carries in its conductive state the same current which serves as a reference unit, whereas the remaining auxiliary driver circuits carry different currents corresponding to succeeding powers of two of the reference unit.

4. Circuit arrangement as claimed in any one of claims 1 to 3, characterized in that the driver circuits and one of the auxiliary driver circuits have the same load resistors, whereas the load resistors of the other auxiliary driver circuits have lower values which with respect to the load resistors of the same value correspond to the reciprocals of succeeding powers of two.

5. Circuit arrangement as claimed in any one of claims 1 to 4, characterized in that between the input signal lines and the driver circuits gating circuits (31–37) are arranged whose control inputs are connected to a common control line (38).

6. Circuit arrangement as claimed in any one of claims 1 to 5, characterized in that the control circuit for the auxiliary driver circuits comprises several adders (101–104).

7. Circuit arrangement as claimed in any one of claims 1 to 6, characterized in that the auxiliary driver circuits are controlled via OR gates (87–89) with two inputs whose first inputs are interconnected and connected via an inverter (80) to the common control line for the driver circuit gates, whereas the second inputs of the OR gates are connected via inverters (97–99) to outputs of the adders.

## Revendications

1. Montage supprimant les tensions parasites et constitué par plusieurs circuits d'attaque alimentés en commun, pour des signaux de données à deux niveaux, et dans lequel chaque circuit d'attaque est relié à une ligne respective faisant partie de plusieurs lignes (11–17) de transmission de signaux d'entrée, caractérisé en ce que, pour la suppression de tensions parasites qui apparaissent lors de la commutation des étages d'attaque en raison de l'inductance des lignes d'alimentation en courant, il est prévu une série de circuits d'attaque auxiliaires (67–69), qui sont raccordés à la même source de tension d'alimentation (+E) que les autres circuits d'attaque (21–27), et un circuit de commande (80–104) pour les circuits d'attaque auxiliaires, que les entrées du circuit de commande sont raccordées aux lignes (11–17) de transmission de signaux d'entrée et que leurs sorties sont raccordées aux circuits d'attaque auxiliaires et que le circuit de commande détermine le nombre des circuits d'attaque, qui sont raccordés aux lignes de transmission de signaux d'entrée et auxquels un niveau du signal de données est envoyé, et branche un nombre correspondant des circuits d'attaque auxiliaires pour maintenir constant le courant prélevé de la source de tension d'alimentation.

2. Montage selon la revendication 1, caractérisé en ce que les sorties (X, Y, Z) des circuits d'attaque auxiliaires sont reliées à des circuits de contrôle d'erreurs.

3. Montage selon les revendications 1 et 2, caractérisé en ce que chacun des circuits d'attaque et l'un des circuits d'attaque auxiliaires à l'état conducteur conduisent le même courant qui sert d'unité de référence, tandis que les autres circuits d'attaque auxiliaires conduisent des courants différents qui correspondent à des puissances de deux successives de l'unité de référence.

4. Montage selon les revendications 1 à 3, caractérisé en ce que les circuits d'attaque et l'un des circuits d'attaque auxiliaires possèdent des résistances de charge identiques, tandis que les résistances de charge des autres circuits d'attaque auxiliaires possèdent des valeurs plus faibles qui correspondent, en rapport avec les résistances de charge de même valeur, aux valeurs inverses de puissances de deux successives.

5. Montage selon les revendications 1 à 4, caractérisé en ce qu'entre les lignes de transmission de signaux d'entrée et les circuits d'attaque se trouvent disposés des circuits de porte (31–37), dont les entrées de commande sont raccordées à une ligne de commande commune (38).

6. Montage selon les revendications 1 à 5, caractérisé en ce que le circuit de commande prévu pour les circuits d'attaque auxiliaires contient plusieurs additionneurs (101–104).

7. Montage selon les revendications 1 à 6, caractérisée en ce que les circuits d'attaque auxiliaires sont commandés par l'intermédiaire de circuits OU (87–89) comportant deux entrées et dont les premières entrées sont reliées entre elles et, par l'intermédiaire d'un inverseur (81) à la ligne de commande commune pour les circuits de porte des circuits d'attaque, tandis que les secondes entrées des circuits OU sont reliées par l'intermédiaire d'inverseurs (97–99) à des sorties des additionneurs.

FIG. 1

FIG. 2

FIG. 3

AUGEND
EIN

ADDEND
EIN

Ü ÜBERTRAG
EIN

S
SUM. AUS

Ü
ÜBERTRAG AUS

FIG. 4